# FASCICULE DE BREVET EUROPEEN

(11) **EP 0 795 624 B1**
(45) Date de publication et mention de la délivrance du brevet: **22.09.1999**
(21) Numéro de dépôt: 97410032.3
(22) Date de dépôt: 14.03.1997
(51) Int. Cl.: C23C 14/50, H01L 21/00

(54) **Support de substrats pour installation d'évaporation**
Substrathalter für Verdampfungsvorrichtung
Substrate holder for evaporation apparatus

(30) Priorité: 15.03.1996 FR 9603470
(43) Date de publication de la demande: 17.09.1997
(73) Titulaire: STMicroelectronics S.A., 94250 Gentilly (FR)
(72) Inventeur: Genard, Dominique, 37230 Pernay (FR); Pinsault, Georges, 37100 Tours (FR)
(74) Mandataire: de Beaumont, Michel

(56) Documents cités:
- EP-A- 0 349 364
- PATENT ABSTRACTS OF JAPAN vol. 007, no. 239 (E-206), 25 Octobre 1983 & JP 58 128724 A (HITACHI SEISAKUSHO KK), 1 Août 1983,
- PATENT ABSTRACTS OF JAPAN vol. 016, no. 358 (C-0970), 4 Août 1992 & JP 04 110466 A (OKI ELECTRIC IND CO LTD), 10 Avril 1992,

## Description

La présente invention concerne un support de substrats du type généralement utilisé dans une installation d'évaporation de matériaux sur des substrats. Elle sera décrite dans une application à des dépôts de composés métalliques sur des composants semiconducteurs en cours de fabrication sur des tranches ou plaquettes de silicium mais il sera clair qu'elle s'applique à tout type de substrat.

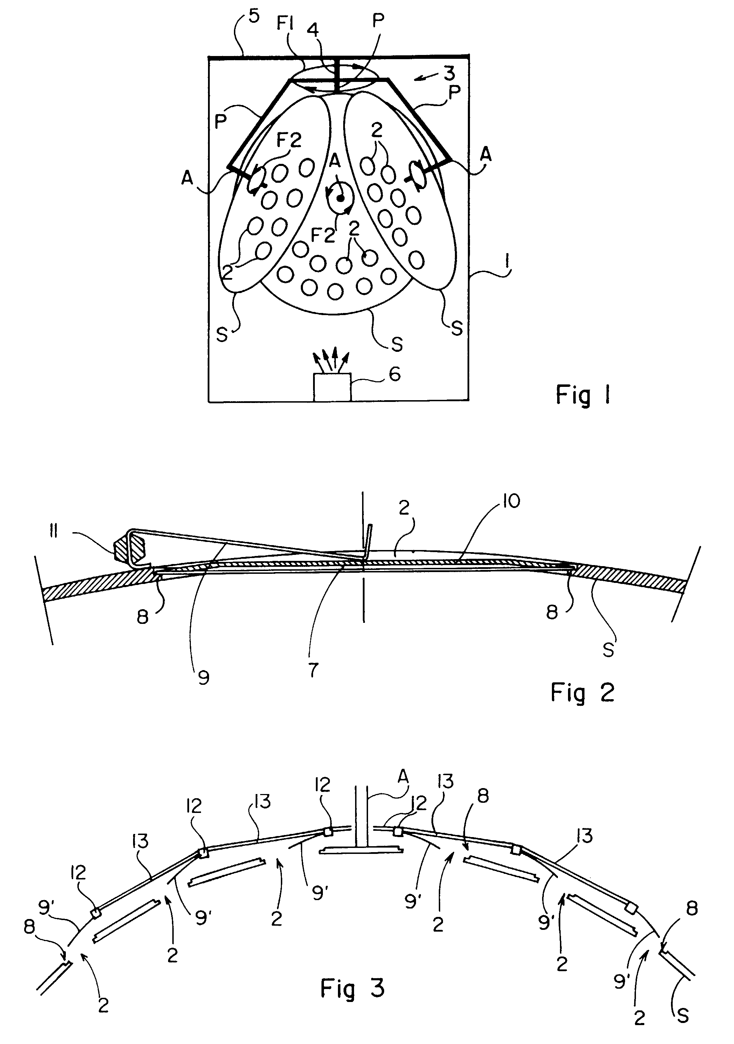

La figure 1 représente schématiquement une installation d'évaporation classique du type à laquelle s'applique la présente invention. Une telle installation est constituée d'une enceinte sous vide 1 à l'intérieur de laquelle sont généralement agencés trois supports S.

Chaque support, en forme de cloche, est formé d'une surface concave à périphérie circulaire, dans laquelle sont ménagées des ouvertures 2, généralement circulaires, de réception de tranches de silicium, les surfaces à traiter des tranches étant dirigées vers l'intérieur (la concavité des supports). A la figure 1, seules quelques ouvertures 2 des supports S ont été représentées, mais tous les supports sont pourvus d'ouvertures sur toute leur surface.

Chaque support S est monté à rotation sur un arbre A orthogonal à sa surface au niveau de son sommet. Les arbres A sont portés par un bâti de suspension commun 3, lui-même monté à rotation sur un arbre principal vertical 4 porté par une paroi supérieure 5 de l'enceinte 1. Le bâti 3 porte des potences P aux extrémités libres desquelles sont liés les arbres A. Le mouvement de rotation du bâti 3 imprime, généralement par des engrenages coniques (non représentés) un mouvement de rotation à des arbres de transmission (non représentés) contenus dans les potences P qui transmettent le mouvement rotatif, par des moyens similaires, aux arbres A. Les mouvements de rotation du bâti 3 et des supports S sont illustrés à la figure 1 par des flèches, respectivement, F1 et F2. Les supports S sont généralement appelés des "planétaires" en raison de leurs mouvements excentriques respectifs. Les surfaces internes des supports sont tournées vers une source d'évaporation 6 contenue dans l'enceinte 1.

Un cycle d'évaporation consiste à charger l'enceinte 1 avec des planétaires S portant des plaquettes à traiter, à effectuer un pompage sous vide de l'intérieur de l'enceinte 1, à chauffer l'espace interne de l'enceinte 1, à exciter la source d'évaporation 6 pour provoquer un dépôt, puis à refroidir et à ventiler l'enceinte, et à extraire les supports S. Les mouvements de rotation, imprimés au bâti 3 et aux supports S, assurent un dépôt uniforme sur les surfaces à traiter. Le fonctionnement d'une telle installation est connu.

Les axes A des supports S sont montés de manière amovible sur les potences P pour permettre d'extraire les supports S de l'enceinte 1 afin de les décharger des plaquettes traitées et d'y positionner des plaquettes à traiter. Pendant les opérations de chargement/déchargement de plaquettes, le support repose généralement par sa périphérie circulaire sur un plateau tournant que l'utilisateur fait tourner au fur et à mesure qu'il positionne où décharge les plaquettes.

La figure 2 représente, partiellement et en coupe, un exemple de support S classique au niveau d'une ouverture 2 destinée à recevoir une plaquette de silicium 7. Chaque ouverture 2 présente un épaulement périphérique 8 sur lequel repose, par sa surface devant être exposée, la périphérie de la plaquette 7. La plaquette 7, positionnée depuis l'extérieur du support, est maintenue en place au moyen d'un ressort 9 avec interposition d'un cache 10 recouvrant toute la face externe de la plaquette 7. Le rôle du cache 10 est d'éviter que la force exercée par le ressort 9 ne brise la plaquette 7 qui est généralement très fine (par exemple, de l'ordre de 0,3 à 0,6 mm). Le cache 10 sert également à protéger la surface externe de la plaquette 7 pour éviter que celle-ci ne soit souillée lors du processus d'évaporation, en particulier si les deux faces de la plaquette de silicium constituent des surfaces utiles, par exemple, destinées à recevoir chacune un dépôt.

Un inconvénient d'un support classique est que l'épaulement 8 sur lequel repose la périphérie de la plaquette crée une zone périphérique de la surface de la plaquette qui se trouve masquée lors de l'évaporation. En raison des tolérances de positionnement d'une plaquette 7 dans une ouverture 2, cette zone inutilisable de la plaquette a généralement une largeur de 1 à 4 mm. Il en résulte une perte de surface utile de la plaquette 7 qui nuit au rendement de l'installation rapporté au nombre de puces susceptibles d'être traitées. Le pourcentage de puces inutilisables, car non-traitées sur toute leur surface, dépend de la taille unitaire des puces qui sont formées sur la plaquette.

Un autre inconvénient des supports classiques tels que décrits ci-dessus est que le recours nécessaire à un cache derrière chaque plaquette augmente la durée nécessaire de chargement et de déchargement d'un lot de plaquettes sur un support.

Un autre inconvénient d'un support classique de ce type est que le ressort 9 doit être dégagé de l'ouverture par l'utilisateur préalablement à l'extraction ou au positionnement du cache 10 et de la plaquette 7. De ce fait, une fois que le ressort a été dégagé, par exemple par rotation par rapport à son point d'ancrage 11 en périphérie de l'ouverture 2, la plaquette 7 n'est pas retenue dans son logement lors du positionnement ou de l'extraction du cache 10. La plaquette risque donc de s'échapper de son logement notamment en raison de la forme concave du support S. De plus, même si l'épaulement 8 participe à un positionnement correct de la plaquette 7, si cette dernière quitte partiellement son logement avant la mise en place du cache 10 et du ressort 9, l'utilisateur risque de ne pas s'en apercevoir et la plaquette se trouve alors mal positionnée avec, de plus, un risque de casse sous l'action du ressort dans la mesure où elle se trouve en porte-à-faux.

La figure 3 représente, schématiquement et en coupe, un deuxième exemple de moyens de maintien des plaquettes sur un support classique. Pour des raisons de clarté, les plaquettes 7 et les caches 10 n'ont pas été représentés à la figure 3. Tous les ressorts 9' sont portés par des couronnes concentriques 12 reliées entre elles par des tiges 13, chaque couronne 12 portant plusieurs ressorts 9' répartis en fonction de la position des ouvertures 2 du support S. On obtient ainsi une structure, distincte du support S, qui comprend tous les ressorts 9' et qui est rapportée sur le support S et maintenue, par exemple par vissage (non représenté), à ce dernier une fois que toutes les plaquettes et tous les caches ont été positionnés.

Si une telle structure permet d'éviter une manipulation individuelle des ressorts, elle présente, outre les mêmes inconvénients que le premier exemple de moyens de maintien illustré par la figure 2, plusieurs autres inconvénients. Tout d'abord, elle augmente l'épaisseur globale du support, ce qui nuit à la compacité de l'installation globale. De plus, le support se trouve sensiblement alourdi par la présence d'une telle structure. En outre, comme l'utilisateur ne manipule plus les ressorts individuellement, la force des ressorts n'est pas contrôlée à chaque positionnement de plaquette. Ainsi, l'utilisateur ne s'aperçoit pas qu'un ressort est usé, donc inefficace, ce qui entraîne un risque de chute de plaquette du support lorsqu'il est entraîné en rotation dans l'enceinte.

Un autre inconvénient commun aux deux exemples de moyens de maintien classiques décrits ci-dessus est que la présence d'ouvertures 2 dans le support nécessite que ce dernier soit suffisamment épais, ou renforcé, pour présenter une rigidité suffisante malgré les ouvertures 2. Généralement, les supports sont réalisés en acier inox de 2,5 mm d'épaisseur.

Le document JP-A-04110466 décrit un support individuel de plaquette dans lequel la surface supportant la plaquette a une forme adaptée pour favoriser le maintien de la plaquette au moyen d'un ressort.

La présente invention vise à pallier les inconvénients des supports connus en proposant un support de substrats destiné à une installation d'évaporation qui supprimé toute perte de surface utile des substrats traités.

L'invention vise également à proposer un support qui supprime tout risque de bris de substrat lors des étapes de positionnement et de déchargement d'un lot de substrats du support.

L'invention vise également à proposer un support de substrats pour lequel les opérations de positionnement et de chargement des substrats soient simplifiées.

Pour atteindre ces objets, la présente invention prévoit un support de substrats de forme concave destiné à une installation d'évaporation, constitué d'une surface sensiblement pleine et pourvu de moyens élastiques de maintien de substrats positionnés contre une face intérieure du support, les moyens de maintien étant actionnables depuis une face externe du support.

Selon un mode de réalisation de la présente invention, chaque moyen de maintien d'un substrat est actionnable individuellement.

Selon un mode de réalisation de la présente invention, chaque moyen de maintien est fixé audit support depuis ladite face externe et comporte une patte traversant une lumière réalisée dans le support au voisinage d'un emplacement destiné à un substrat, ladite patte étant destinée à appuyer contre la tranche dudit substrat.

Selon un mode de réalisation de la présente invention, la face interne du support est pourvue d'au moins une butée destinée à coopérer avec les moyens élastiques de maintien, la butée étant sensiblement opposée à la lumière par rapport au centre de l'emplacement.

Selon un mode de réalisation de la présente invention, chaque emplacement est défini par un retrait de la face interne du support.

Selon un mode de réalisation de la présente invention, chaque moyen de maintien est constitué d'un ressort en épingle dont deux branches sont maintenues à l'extérieur du support, une première branche se terminant, à son extrémité libre, par la patte traversant la lumière et une deuxième branche constituant un moyen d'actionnement du ressort depuis l'extérieur du support.

Selon un mode de réalisation de la présente invention, chaque moyen de maintien est constitué d'un ressort à lame dont une première extrémité est fixée à la face externe du support et dont une deuxième extrémité porte la patte d'appui contre la tranche d'un substrat.

Selon un mode de réalisation de la présente invention, la patte comporte un prolongement dirigé vers l'extérieur du support pour constituer un moyen d'actionnement du ressort depuis l'extérieur du support.

La présente invention s'applique à une installation d'évaporation pour dépôt de composés métalliques sur des composants semiconducteurs en cours de fabrication sur des plaquettes de silicium.

Une caractéristique de la présente invention est que le support de substrats est sensiblement plein, c'est-à-dire qu'il est dépourvu d'ouvertures permettant, dans l'art antérieur, de positionner les substrats. Par conséquent, les substrats sont, selon l'invention, positionnés sur le support depuis la face externe de celui-ci.

Un avantage de la présente invention est que la surface des substrats soumise à évaporation correspond désormais à la surface totale des substrats. Ainsi, pour un dépôt de composés métalliques sur des composants semiconducteurs en cours de fabrication sur des tranches ou plaquettes de silicium, on obtient un gain de rendement du processus d'évaporation rapporté au nombre de puces pouvant être traitées.

Un autre avantage de la présente invention est qu'elle supprime le recours à des caches rapportés sur la face externe des plaquettes, ce qui diminue le temps nécessaire pour charger ou décharger un support par un lot de plaquettes.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 qui ont été décrites précédemment sont destinées à exposer l'état de la technique et le problème posé ;
la figure 4 représente partiellement, vu de dessus depuis l'intérieur, un mode de réalisation d'un support de substrats selon la présente invention ;
la figure 5 représente, sous la forme d'une coupe prise le long de la ligne A-A' de la figure 4, un emplacement d'un substrat dans un support selon la présente invention ;
la figure 6 représente, en perspective, un premier mode de réalisation d'un moyen de maintien d'un substrat selon l'invention ; et
la figure 7 représente, en perspective, un deuxième mode de réalisation d'un moyen de maintien d'un substrat selon l'invention.

Pour des raisons de clarté, les mêmes éléments ont été désignés par les mêmes références aux différentes figures. De même, les représentations des figures ne sont pas à l'échelle.

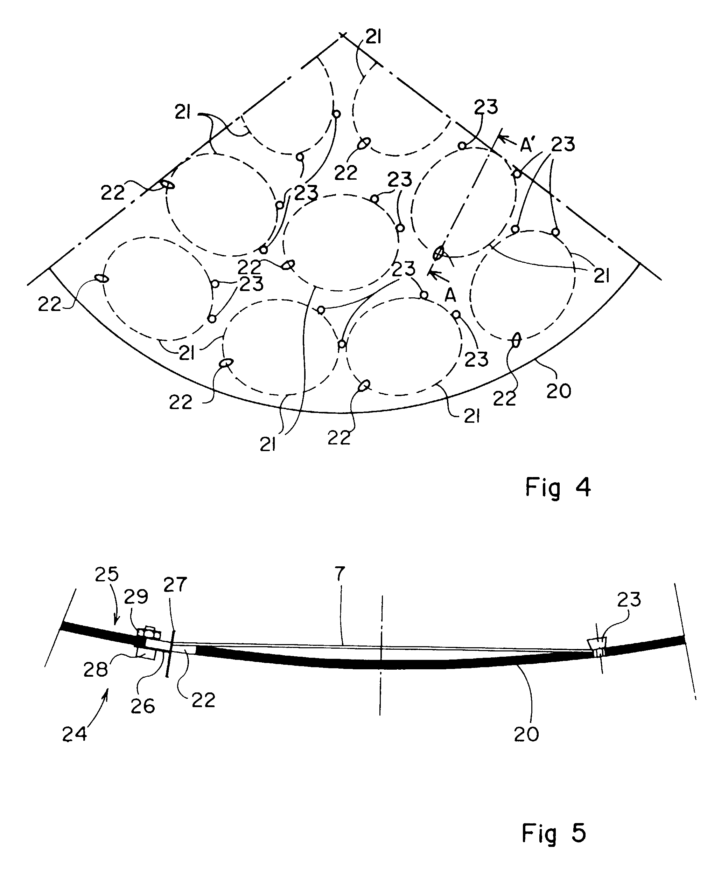

La figure 4 illustre, par une vue partielle de dessus depuis l'intérieur, un mode de réalisation d'un support de substrats 20 selon la présente invention.

Le support 20, en forme de cloche, est formé d'une surface concave pleine à périphérie circulaire dont l'intérieur est destiné à recevoir des tranches ou plaquettes de silicium, les surfaces à traiter des tranches étant dirigées vers l'intérieur (la concavité du support 20).

A la figure 4, les emplacements 21 des plaquettes ont été représentés par des cercles pointillés, la forme écrasée des cercles en périphérie provenant de la forme concave du support 20.

Selon l'invention, une lumière 22 de faibles dimensions par rapport à la taille d'une plaquette est réalisée à la périphérie de chaque emplacement 21 destiné à une plaquette. Les lumières 22 sont destinées à permettre le passage, depuis l'extérieur du support, d'un moyen élastique de maintien de la plaquette positionnée dans l'emplacement 21 auquel la lumière 22 est associée.

Au moins une butée latérale 23 est disposée de façon diamétralement opposée à la lumière 22 de chaque emplacement 21. De préférence, au moins deux butées 23 sont prévues sur la périphérie de l'emplacement 21 à l'opposé de la lumière 22.

La figure 5 est une coupe partielle prise le long de la ligne A-A' de la figure 4.

Une caractéristique de l'invention est que les moyens de maintien des plaquettes sont actionnables depuis la face externe 24 du support 20 alors qu'ils agissent sur les plaquettes 7 depuis la face interne 25 du support.

Chaque moyen de maintien associé à un emplacement 21 est constitué d'un ressort 26 fixé, par exemple, par un boulon 28 traversant le support 20 et par un écrou 29, le ressort 26 étant situé à l'extérieur du support 20. Le ressort 26 comporte une patte 27 qui débouche en face intérieure 25 par la lumière 22 pour appuyer contre la tranche de la plaquette 7.

La lumière 22 définit, dans sa longueur, la plage de déplacement de la patte 27 du ressort. Les figures 4 et 5 montrent que la lumière 22 mord sur l'emplacement 21 auquel elle est associée afin d'assurer que la patte 27 appuie contre la tranche d'une plaquette 7 engagée dans l'emplacement 21. A l'inverse, en l'absence de plaquette 7 dans l'emplacement 21, la patte 27 vient en butée contre l'extrémité longitudinale de la lumière 22 côté emplacement 21. On veillera à ce que la longueur de la lumière 22 soit suffisante, hors de l'emplacement 21, pour permettre un dégagement de la patte 27 lors du positionnement ou du déchargement d'une plaquette 7.

Comme l'illustre la figure 5, la ou les butées 23 ne masquent pratiquement pas la surface exposée de la plaquette. Elles peuvent cependant avoir une forme légèrement tronconique, comme cela est représenté, pour assurer un meilleur positionnement et maintien de la plaquette poussée contre la ou les butées 23 par le ressort 26.

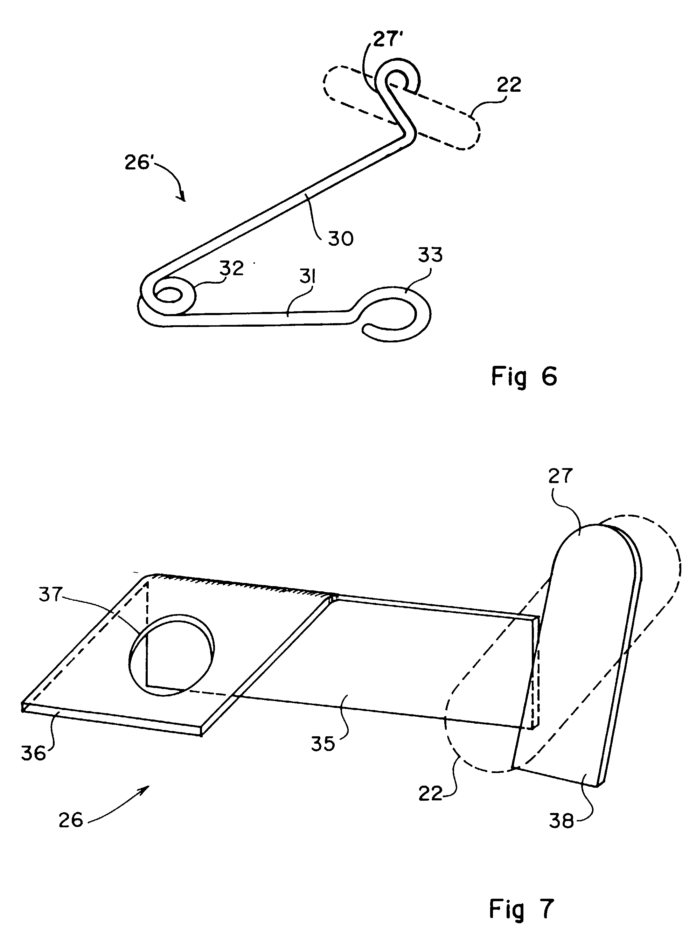

Les figures 6 et 7 représentent deux modes de réalisation d'un ressort 26 destiné à maintenir une plaquette dans son emplacement.

Selon un premier mode de réalisation (figure 6), chaque ressort 26' est un ressort en épingle dont les deux branches 30 et 31 sont situées à l'extérieur du support 20 (non représenté à la figure 6) en étant réunies par une boucle 32 définissant un logement de réception d'un moyen de fixation, par exemple un boulon (non représenté), pour fixer le ressort 26' au support 20. Une première branche 30, proximale de la surface 24 (non représentée à la figure 6), se termine par une patte 27' dans un plan perpendiculaire aux plans définis par les déplacements des branches 30 et 31 lorsque le ressort 26' est actionné. La patte 27' est destinée à traverser la lumière 22 (représentée en pointillés à la figure 6) et présente, par exemple, une forme de col de cygne. Une deuxième branche 31 constitue un organe d'actionnement du ressort 26' et se termine, par exemple, par un anneau 33 coplanaire au plan de la branche 31.

Selon un deuxième mode de réalisation (figure 7), chaque ressort 26 est un ressort à lame. Un ressort 26 comprend une lame 35 côté extérieur du support 20 (non représenté à la figure 7). Cette lame 35 se termine, à une première extrémité, par une platine 36 pourvue d'un trou 37 destiné au passage d'un boulon 28 (figure 5) de fixation au support 20. La lame 35 se termine, à une deuxième extrémité, par une patte 27 destinée à traverser une lumière 22 (représentée en pointillés à la figure 7) du support 20. La patte 27 est dans un plan parallèle ou légèrement incliné vers l'emplacement 21 (figure 4) par rapport au plan de la lame 35 alors que la platine 36 se trouve dans un plan perpendiculaire à la lame 35. Le moyen d'actionnement du ressort 26 est constitué, à l'extérieur du support 20, directement par la lame 35 ou, le cas échéant, par un prolongement 38 symétrique à la patte 27 par rapport à la lame 35.

Un avantage de ce deuxième mode de réalisation est qu'il permet que la patte 27 appuie contre la tranche d'une plaquette par une surface plane, ce qui évite tout risque d'endommagenent de la plaquette en l'ébréchant par un relâchement du ressort.

Si les plaquettes présentent un bord coupé rectiligne, ce qui est souvent le cas, les plaquettes sont alors positionnées par l'utilisateur pour que ce bord coupé reçoive la face d'appui de la patte 27, ce qui améliore encore le positionnement et le maintien de la plaquette.

Le chargement et le déchargement d'un lot de plaquettes sur un support s'effectuent de la manière suivante. Le support est placé dans une position où sa surface interne 25 est accessible. De préférence, le support 20 est monté au moyen de son axe (A) sur un outillage adapté permettant de le laisser libre en rotation afin que l'utilisateur puisse, comme précédemment, faire tourner le support 20 au fur et à mesure de son chargement ou déchargement.

D'une main, l'utilisateur actionne un ressort 26 ou 26' par le dessous du support et de l'autre main, il prélève ou pose une plaquette à l'emplacement 21 correspondant, par exemple et de manière classique, au moyen d'une pipette, puis une fois que la plaquette est en place ou a été retirée, il relâche le ressort.

De préférence, tous les ressorts sont situés sensiblement d'un même côté des emplacements 21 répartis sur le support afin d'en faciliter l'accès par l'utilisateur.

Bien que cela ne soit pas indispensable en raison du blocage immédiat d'une plaquette dès sa mise en place dans le support, on peut prévoir que les emplacements 21 soient définis dans la face interne 25 du support 20 par un léger retrait (non représenté) de cette surface 25 dans les emplacements 21 afin de faciliter le positionnement correct des plaquettes.

L'utilisation d'un support selon l'invention est donc particulièrement simple. Le fait que l'utilisateur agisse sur chaque ressort individuellement et directement permet de s'assurer, à chaque chargement ou déchargement, de l'état de chaque ressort.

Un avantage de la présente invention est que, comme la surface du support est sensiblement pleine, il est désormais possible de le rendre moins épais sans nuire à sa rigidité et/ou d'utiliser des matériaux ayant une densité plus faible que l'acier inox, par exemple, du titane.

Bien entendu, la présente invention est susceptible de diverses variantes et modifications qui apparaîtront à l'homme de l'art, notamment pour ce qui concerne la répartition des emplacements 21, des lumières 22 et des butées 23 ainsi que des ressorts 26 ou 26' et de leurs moyens de fixation.

De plus, la réalisation pratique des ressorts 26 ou 26', en particulier le choix de leur raideur, est à la portée de l'homme du métier en fonction de la taille de plaquettes à laquelle est destinée la présente invention.

En outre, d'autres moyens de fixation des ressorts peuvent être prévus. On préférera cependant utiliser des moyens démontables pour faciliter le remplacement des ressorts usés.

## Revendications

1. Support de substrats du type à forme concave destiné à une installation d'évaporation, caractérisé en ce qu'il est constitué d'une surface sensiblement pleine, destinée à recevoir plus de un substrat (7), et est pourvu de moyens élastiques (26, 26') de maintien de substrats (7) positionnés contre une face intérieure (25) du support (20), lesdits moyens de maintien (26, 26') étant actionnables depuis une face externe (24) du support (20).

2. Support de substrat selon la revendication 1, caractérisé en ce que chaque moyen de maintien (26, 26') d'un substrat (7) est actionnable individuellement.

3. Support de substrats selon la revendication 1 ou 2, caractérisé en ce que chaque moyen de maintien (26, 26') est fixé audit support (20) depuis ladite face externe (24) et comporte une patte (27, 27') traversant une lumière (22) réalisée dans le support (20) au voisinage d'un emplacement (21) destiné à un substrat (7), ladite patte (27, 27') étant destinée à appuyer contre la tranche dudit substrat (7).

4. Support de substrats selon la revendication 3, caractérisé en ce que ladite face interne (25) du support (20) est pourvue d'au moins une butée (23) destinée à coopérer avec lesdits moyens élastiques de maintien (26, 26'), ladite butée (23) étant sensiblement opposée à ladite lumière (22) par rapport au centre de l'emplacement (21).

5. Support de substrats selon la revendication 3 ou 4, caractérisé en ce que chaque emplacement (21) est défini dans la face interne (25) du support (20) par un retrait de la surface du support.

6. Support de substrats selon l'une quelconque des revendications 1 à 5, caractérisé en ce que chaque moyen de maintien est constitué d'un ressort en épingle (26') dont deux branches (30, 31) sont maintenues à l'extérieur du support (20), une première branche (30) se terminant, à son extrémité libre, par ladite patte (27') traversant ladite lumière (22) et une deuxième branche (31) constituant un moyen d'actionnement du ressort (26') depuis l'extérieur du support (20).

7. Support de substrats selon l'une quelconque des revendications 1 à 5, caractérisé en ce que chaque moyen de maintien est constitué d'un ressort à lame (26) dont une première extrémité est fixée à la face externe (24) du support (20) et dont une deuxième extrémité porte ladite patte (27) d'appui contre la tranche d'un substrat (7).

8. Support de substrats selon la revendication 7, caractérisé en ce que ladite patte (27) comporte un prolongement (28) dirigé vers l'extérieur du support pour constituer un moyen d'actionnement du ressort (26) depuis l'extérieur du support (20).

9. Support de substrats selon l'une quelconque des revendications 1 à 8, caractérisé en ce qu'il est destiné à une installation d'évaporation pour dépôt de composés métalliques sur des composants semiconducteurs en cours de fabrication sur des plaquettes de silicium (7).

10. Installation d'évaporation de matériaux sur des substrats, caractérisée en ce qu'elle comporte des supports (20) de substrats (7) selon l'une quelconque des revendications 1 à 8.

## Claims

1. A concave substrate support for an evaporation installation, characterized in that it has a substantially solid surface for accomodating more than one substrate (7), and is provided with resilient means (26, 26') for holding substrates (7) positioned against an inner surface (25) of the support (20), the holding means (26, 26') being operable from an outer surface (24) of the support (20).

2. A substrate support according to claim 1, characterized in that each holding means (26, 26') of a substrate (7) is operable individually.

3. A substrate support according to claim 1 or 2, characterized in that each holding means (26, 26') is attached to said support (20) from said outer surface (24) and includes a tab (27, 27') extending through a port (22) provided in the support (20) in the vicinity of a location (21) provided for a substrate (7), the tab (27, 27') being meant to bear against the edge of the substrate (7).

4. A substrate support according to claim 3, characterized in that the inner surface (25) of the support (20) is provided with at least one stop (23) for cooperating with the resilient holding means (26, 26'), the stop (23) being located substantially opposite to the port (22) with respect to the center of the location (21).

5. A substrate support according to claim 3 or 4, characterized in that each location (21) is defined by a recess of the inner surface (25) of the support (20).

6. A substrate support according to any of claims 1 to 5, characterized in that each holding means is comprised of a hairpin spring (26'), two branches (30, 31) of which are maintained outside the support (20), a first branch (30) terminating, at its free end, with the tab (27') extending through the port (22) and a second branch (31) constituting a means for operating the spring (26') from the outside of the support (20).

7. A substrate support according to any of claims 1 to 5, characterized in that each holding means is comprised of a leaf spring (26), a first end of which is attached to the outer surface (24) of the support (20) and a second end of which supports the tab (27) for bearing against the edge of a substrate (7).

8. A substrate support according to claim 7, characterized in that said tab (27) includes an extension (28) directed towards the outside of the support to constitute a means for operating the spring (26) from the outside of the support (20).

9. A substrate support according to any of claims 1 to 8, characterized in that it is meant for an evaporation installation for depositing metallic compounds on semiconductor components being manufactured on silicon wafers (7).

10. An installation for evaporating materials on substrates, characterized in that it includes supports (20) of substrates (7) according to any of claims 1 to 8.

## Patentansprüche

1. Konkaver Substratträger für eine Verdampfungseinrichtung, dadurch **gekennzeichnet**, daß er eine im wesentlichen durchgehende Oberfläche zum Aufnehmen von mehr als einem Substrat (7) sowie eine elastische Vorrichtung (26, 26') zum Halten von Substraten (7) aufweist, welche gegen eine Innenfläche (25) des Trägers (20) positioniert sind, wobei die Haltevorrichtung (26, 26') von einer Außenseite (24) des Trägers (20) bedienbar ist.

2. Substratträger nach Anspruch 1, dadurch **gekennzeichnet**, daß jede Haltevorrichtung (26, 26') für ein Substrat (7) individuell bedienbar ist.

3. Substratträger nach Anspruch 1 oder 2, dadurch **gekennzeichnet**, daß jede Haltevorrichtung (26, 26') an dem Träger (20) von der Außenseite (24) her angebracht ist und eine Lasche (27, 27') aufweist, die sich durch eine Öffnung (22) erstreckt, die in dem Träger (20) in der Nachbarschaft eines Ortes (21), der für ein Substrat (7) vorgesehen ist, ausgebildet ist, wobei die Lasche (27, 27') gegen den Rand des Substrats (7) zu liegen kommen soll.

4. Substratträger nach Anspruch 3, dadurch **gekennzeichnet**, daß die Innenseite (25) des Trägers (20) mit wenigstens einem Anschlag (23) versehen ist, der mit der elastischen Haltevorrichtung (26, 26') zusammenwirkt, wobei der Anschlag (23) der Öffnung (22) in bezug auf das Zentrum des Ortes (21) im wesentlichen gegenüberliegt.

5. Substratträger nach Anspruch 3 oder 4, dadurch **gekennzeichnet**, daß jeder Ort (21) durch eine Ausnehmung an der Innenseite (25) des Trägers (20) definiert ist.

6. Substratträger nach einem der Ansprüche 1 bis 5, dadurch **gekennzeichnet**, daß jede Haltevorrichtung eine Schnappfeder (26') aufweist, wobei zwei Arme (30, 31) der Feder außerhalb des Trägers (20) gchalten werden, wobei ein erster Arm (30) mit seinem freien Ende bei der Lasche (27') endet, welche durch die Öffnung (22) geht, und ein zweiter Arm (31) eine Vorrichtung zum Bedienen der Feder (26') von außerhalb des Trägers (20) bildet.

7. Substratträger nach einem der Ansprüche 1 bis 5, dadurch **gekennzeichnet**, daß jede Haltevorrichtung eine Blattfeder (26) aufweist, wobei ein erstes Ende der Feder an der Außenseite (24) des Trägers (20) angebracht ist und ein zweites Ende die Lasche (27) trägt, so daß sie gegen den Rand eines Substrats (7) anliegt.

8. Substratträger nach Anspruch 7, dadurch **gekennzeichnet**, daß die Lasche (27) eine Verlängerung (28) aufweist, die in Richtung der Außenseite des Trägers gerichtet ist, um eine Vorrichtung zum Bedienen der Feder (26) von außerhalb des Trägers (20) vorzusehen.

9. Substratträger nach einem Ansprüche 1 bis 8, dadurch **gekennzeichnet**, daß sie für eine Verdampfungseinrichtung bestimmt ist, um metallische Komponenten auf Halbleiterkomponenten während der Herstellung von Siliziumwafern (7) aufzubringen.

10. Einrichtung zum Aufdampfen von Materialien auf Substrate, dadurch **gekennzeichnet**, daß die Substratträger (20,7) nach einem der Ansprüche 1 bis 8 aufweist.
